(19) Europäisches Patentamt
European Patent Office
Office européen des brevets

(11) EP 0 952 498 A1

(12) **EUROPEAN PATENT APPLICATION**

(43) Date of publication:
**27.10.1999 Bulletin 1999/43**

(51) Int. Cl.[6]: **G03G 15/34**, H05K 3/06

(21) Application number: **98201302.1**

(22) Date of filing: **22.04.1998**

(84) Designated Contracting States:
**AT BE CH CY DE DK ES FI FR GB GR IE IT LI LU MC NL PT SE**
Designated Extension States:
**AL LT LV MK RO SI**

(71) Applicant: **AGFA-GEVAERT N.V.**
**2640 Mortsel (BE)**

(72) Inventors:
- **Desie, Guido,**
  **c/o Agfa-Gevaert N.V., IIE 3811**
  **2640 Mortsel (BE)**
- **Daes, Guido,**
  **c/o Agfa Gevaert N.V., IIE 3811**
  **2640 Mortsel (BE)**
- **DeMeutter, Stefaan,**
  **c/o Agfa Gevaert N.V.,IIE 3811**
  **2640 Mortsel (BE)**
- **Willaert, Peter,**
  **c/o Agfa Gevaert N.V., IIE 3811**
  **2640 Mortsel (BE)**

# (54) Direct electrostatic printing process for forming a resist pattern on a conducting surface and use thereof in a fabrication process for printed circuit boards

(57) A direct electrostatic printing process is described for the direct production of a pattern of etch-resistant toner resin on a conductive layer on the surface of a dielectric material (i.e. on a PCB-precursor) that can be used for the production of printed circuit boards (PCB's). A toner image with sufficient etch-resistance (regulated by the toner layer thickness and the toner-insolubility) is applied by a DEP-device, according to a digital image file, directly upon the conductive layer of a PCB precursor. During printing, the distance, L, between the printhead structure and the conductive layer on the PCB-precursor, is adapted to the difference in electric potential, |V|, between the conductive layer and a surface carrying charged toner particles, so that $0.5 \leq |V|/L \leq 2.5$. After fixing/curing, said digitally applied etch-resist-pattern is used in a chemical etching bath to etch the copper on the surface of said dielectric material.

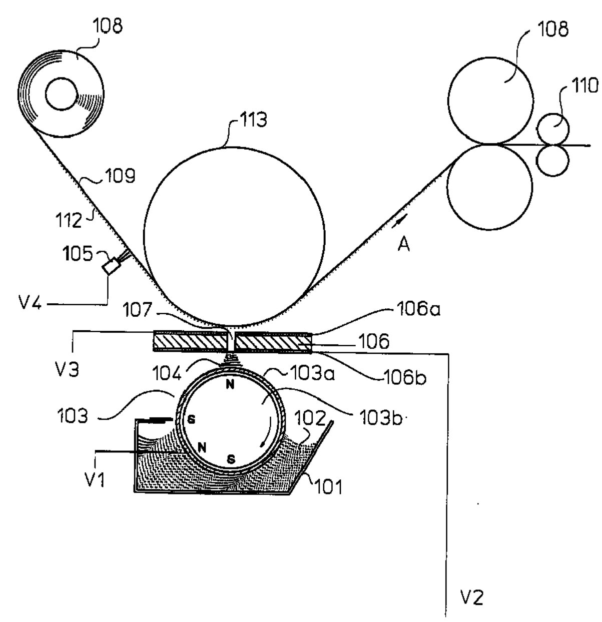


Fig.1

EP 0 952 498 A1

Printed by Xerox (UK) Business Services
2.16.7/3.6

## Description

FIELD OF THE INVENTION

This invention relates to a process for producing printed circuit boards (PCB's) wherein a polymeric mask is applied to the conductive layer on an insulating substrate by a method and an apparatus for Direct Electrostatic Printing (DEP), more particularly to the use of a direct electrostatic printing process with dry toner particles in the fabrication of printed circuit boards (PCB's).

BACKGROUND OF THE INVENTION.

Printed circuit boards (PCB's) typically consist of a substrate made of a dielectric material (such as epoxy, polyimide, polyester or a glass reinforced material) carrying a pattern of conductors on at least one side of said dielectric material. Said materials comprising at least on one side of said dielectric material said conductor paths can also be combined to yield multi-layer PCB structures of up to 20 different layers of dielectric and conducting material.

Many different prior art techniques are known for forming patterns of conductors on a insulating substrate for the production of PCB's (Printed Circuit Board), including subtractive and additive processes or a combination of both.

All these techniques require that part of the substrate surface of the conductive layer on the substrate is protected by a resist pattern (polymer pattern) for the formation of the final conductive paths.

In the additive approach e.g. said (negative image) pattern can be used in a metal plating process for building up the conductive paths. After removal of the resist the final PCB-layer is obtained. However, still more frequently used is the negative process in which a positive image consisting of a resist (a polymer) is formed on a conducting surface of a substrate (e.g. on the metal layer in copper clad epoxy). The copper is etched away in those areas that are not covered with said resist. After removal of the resist the final PCB-layer is obtained. In a combined process a thin conductive layer can be partially thickened by an additive process using a first mask, after which a second mask is applied over said thickened conductors. The first mask is removed, said thin conductors are etched away in a negative process, and after removal of said second mask a final PCB-layer is obtained.

In most processes used today said resist is mostly a layer of photoresist which is applied (coated or laminated) to the metallic conductive layer of said substrate, and which is chemically "altered" most frequently by irradiation with Ultraviolet (UV) light. By image-wise exposure of said photoresist a latent image is formed which is developed to provide the desired resist pattern. Mostly the exposed and non-exposed parts of the layer of photoresist have a different solubility in a solvent, so that part of the layer can be image-wise dissolved away. In many ways said resulting resist pattern is post-conditioned so that its resistance towards the etching chemicals is enhanced.

The image-wise exposure of said resist layer proceeds through a phototool. Such a phototool carries the image of the conductive pattern and is used to image-wise modulate the exposure of the photoresist layer. The production of such phototools is not straightforward and easy and proceeds mostly by the use of rather expensive photoplotters.

For short trial PCB-layouts this conventional method is too slow and direct mask application techniques, wherein the pattern to be etched is directly brought to the resist layer, without the intermediary of a phototool are much more interesting.

In a first type of direct mask application techniques a continuous layer of photoresist is applied to the metal layer on the substrate and by using of laser system the continuous layer is image-wise exposed by image-wise scanning the surface of the layer of resist. Thus the image-wise exposure proceeds without the need of a phototool. These techniques, however, are quite expensive and slow with regard to PCB-yield. Also additive alternatives of this approach exist in which a catalyst layer (e.g. BAYPRINT, commercially available from Bayer Germany, or SENSUL, commercially available from Sensy Belgium) is "structured" by e.g. an excimer laser after which a conductive pattern is formed in an additive process. This method, however, is also very expensive.

Theoretically it must be possible to "print" polymeric resist masks directly to the conductive surface of the PCB precursor (the wording PCB precursor is used to indicate an insulating substrate carrying a continuous conductive layer, whereon an electric circuit can be produced) by conventional direct image forming techniques such as ink jet or electrophotographic printing. In such techniques no continuous layer of photoresist has to be present on the metal layer on the substrate, but in these cases an amount of polymeric material is image-wise deposited on the metal layer, so forming the etch mask. When it were possible to use such techniques, several benefits would be obtained : no need for the application of a continuous layer of photoresist, no need for exposure through an expensive phototool, no need for expensive laser systems in the exposure step, short runs technically and economically possible since most printers can be digitally addressed.

The problem with these printing techniques resides in the fact that the printed pattern has to be physically strong enough to withstand the further etching process.

Most inexpensive ink jet systems are based on water-soluble inks and are therefore not the best choice for a

good resist performance in an aqueous etching bath.

Electrophotographic printing techniques use dry toner particles with a toner resin to develop a latent image on a latent image bearing member forming a toner image, which is then transferred to the metal layer on the substrate and is melted to form a polymeric mask that is less sensitive to aqueous solutions. The thickness of the layer of polymeric particles intended to form the mask that can be applied by electrophotographic printers in a single pass is too thin for good mask performance. Hence only multi-pass (and expensive) printers using intermediate image receptive members are useful for a direct digital process for the formation of a resist pattern. Moreover, since image transfer has to take place from the latent image bearing member to said metal layer of said substrate, there is image deterioration and unsharpness in line thickness.

In Direct Electrostatic Printing (DEP) the toner particles, comprising a toner resin, are directly image-wise deposited on an image receiving member, the latter not bearing any image-wise latent electrostatic image. A clear description of the principles and the basic components of Direct Electrostatic Printing can be found in e.g. **US-A-3,689,935**. This document discloses an electrostatic line printer having a multi-layered particle modulator or printhead structure comprising :

- a layer of insulating material, called isolation layer ;
- a shield electrode consisting of a continuous layer of conductive material on one side of the isolation layer ;
- a plurality of control electrodes formed by a segmented layer of conductive material on the other side of the isolation layer ; and
- at least one row of apertures.

Each control electrode is formed around one aperture and is isolated from each other control electrode.

Selected potentials are applied to each of the control electrodes while a fixed potential is applied to the shield electrode. An overall applied propulsion field between a toner delivery means and a receiving member support projects charged toner particles through a row of apertures of the printhead structure. The intensity of the particle stream is modulated according to the pattern of potentials applied to the control electrodes. The modulated stream of charged particles impinges upon an image receiving member, interposed in the modulated particle stream. The image receiving member is transported in a direction orthogonal to the printhead structure, to provide a line-by-line scan printing. The shield electrode may face the toner delivery means and the control electrode may face the image receiving member. A DC field is applied between the printhead structure and a single back electrode on the receiving member support. This propulsion field is responsible for the attraction of toner to the image receiving member that is placed between the printhead structure and the back electrode.

This printing technique could be very interesting for printing masks directly on the conductive layer of a PCB precursor, since the higher the DC-propulsion field, the higher the amount of toner particles that are deposited on the conductive layer of the PCB precursor and thus the better the resistance of the polymeric mask against attack by etching fluids.

In **EP-A-823 676**, a DEP method for printing upon thick plastic insulating materials is disclosed, wherein a conductive layer is applied on the first face of the insulating material, this layer is then connected to a voltage source, for providing a DC field between said conductive layer and means for delivering toner particles, thus creating a flow of charged toner particles from said means for delivering toner particles to said conductive layer. A printhead structure, having printing apertures and control electrodes around said printing apertures, is interposed between said means for delivering toner particles and said substrate, so that the toner particles can image-wise be modulated and deposited on the conductive layer, where the toner particles are fixed.

When the method exemplified in **EP-A-823 676** was adapted for the printing on a conductive layer in a PCB precursor, it was found that the quality of the mask was still insufficient although a quite thick layer of toner particles could be applied.

There is thus still a need for an improved direct printing system yielding reliable and stable images of high image quality and sharpness upon final image receptive members with a conductive layer on an insulating substrate and that can be further used in the process of PCB-fabrication and in which the resultant toner image has excellent etch-mask properties

## OBJECTS OF THE INVENTION

It is an object of the invention to provide a method for the direct production of an imaged pattern of resist (polymer) on a conductive layer on an insulating substrate that can be used for the production of printed circuit boards (PCB's).

It is a further object of the invention to provide a method for the direct production of an imaged pattern of resist (polymer) on a metal layer on an insulating substrate that can be used for the production of printed circuit boards

(PCB's) and in which the thickness of the toner layer can easily be regulated to a value that is thick enough for the toner mask to be sufficiently inert to the etching process.

Further objects and advantages of the invention will become clear from the description hereinafter.

The above objects are realised by providing a method for the production of a printed circuit board comprising the steps of :

- bringing a PCB-precursor having a conductive layer on an insulating substrate near a surface carrying charged toner particles said conductive layer facing said surface,
- providing an electrical potential difference of |V| volts, between said conductive layer and said surface carrying charged toner particles, for creating a flow of charged toner particles from said surface to said conductive layer,
- positioning a printhead structure with printing apertures and control electrodes between said surface and said conductive layer, at distance L µm from said conductive layer, for image-wise modulating said flow of charged toner particles,
- adapting said potential difference |V| and said distance L to each other so that $0.5 \le |V|/L \le 2.5$ , wherein |V|/L is expressed in Volts/µm,
- depositing said toner particles image wise on said conductive layer,
- fixing said toner particles to said conductive layer for forming a polymeric etching mask on said conductive layer for forming protected and unprotected parts on said conductive layer and
- etching said unprotected parts of said conductive layer.

In a preferred embodiment of the invention, said potential difference V and said distance L are adapted so that $1 \le |V|/L \le 2$ .

BRIEF DESCRIPTION OF THE DRAWING

Fig. 1 is a schematic illustration of a possible embodiment of a DEP device according to the process for forming a resist pattern on a conducting surface and use thereof in a fabrication process for printed circuit boards of the present invention.

DEFINITION

"PCB-precursor": a sheet or web material comprising an insulating substrate and a conductive layer thereon, whereon a polymeric mask can be applied and whereon after etching away the portions not covered by the polymeric mask a printed circuit board (PCB) is produced. ). The conductive layer on a PCB-precursor can be a metal layer, e.g. Cu, AL, etc. or a layer of a conductive polymer, e.g. doped polythiophene, doped polypyrrole, doped polyaniline, doped polyfuran, etc. When etching the circuit, the etching fluid is then adapted to the nature of the conductive layer.

"Polymeric mask": in this document this wording indicates the mask that is printed on the conductive layer of the PCB-precursor by image-wise applying toner particles containing a toner resin.

DETAILED DESCRIPTION OF THE INVENTION

Direct electrostatic printing with dry toner particles comprising a toner resin, could be very interesting for printing masks directly on the conductive layer of a PCB precursor, since the higher the DC-propulsion field (which is directly related to the potential difference between the means for delivering toner particles and the conductive layer on the PCB precursor), the higher the amount of toner particles that are deposited on the conductive layer of the PCB precursor and thus the better the resistance of the polymeric mask against attack by etching fluids.

It was found that when adapting the device for direct electrostatic printing disclosed in **EP-A-823 676** for the direct printing of an etch mask on a PCB precursor, the quality of the etch mask, both in terms of line quality and of resistance to etching fluids, was insufficient. Increasing the potential difference between the means for delivering toner particles and the conductive layer on the PCB precursor, which was, in EP-A 823 676, 1500 V DC, did not give any improvement. It was surprisingly found that there was an optimum potential difference |V| (The value of V is taken as absolute value (|V|) since the value of that potential difference can be either positive or negative, depending on the sign of the charge of the toner particles that are used in the device or method of his invention) which had to be adapted to the distance L between the printhead structure and the conductive layer of the PCB precursor. When the value of |V|/L was between 0.5 and 2.5 and preferably between 1 and 2 (limits included) then good quality etch masks could be printed. This seems to indicate that the resistance to etch liquids is not linearly increased by applying more material,

since then the quality should then be increased by increasing the potential difference V.

The quality of the printing on the PCB precursor was, independently of the type of toner particles used, always better when the ratio |V|/L was within the limits as above. However, using toner particles comprising a toner resin incorporating a radiation curable resin having a Tg > 35 °C did give even better results. The radiation curable resin in such toner particles is preferably a UV-curable resin and is a member selected from the group consisting of unsaturated polyester/polyurethaneacrylate mixture and unsaturated polyester/polyurethane-vinylether mixture. Such toner particles are disclosed in EP-A 821 281, that is incorporated herein by reference. This reference includes, for addition to toner particles solid compositions (I) containing

(a) a solid, oligomeric, cationically polymerisable polyglycidyl ether or ester (II), or a mixture of (II) with a liquid or crystalline monomeric mono-, di- or poly-epoxy resin, or a mixture of (II) with a cyclic acetal, where (II) have a Tg of above 35 °C,
(b) a multifunctional nucleophilic chain transfer agent,
(c) 0.05-3 wt.% photoinitiator for cationic polymerisation (with respect to the amount of a), and
(d) optionally normal additives for coating powders.

These compositions (I) are melted together and the cooled mixture is milled. The exemplified compositions have a Tg between 65 and more than 115 °C.

Other useful UV curable resins for incorporation in toner particles, according to this invention, are powders based on unsaturated polyesters and polyurethaneacrylates, a typical example of such a polymeric UV curable system is available through Hoechts High Chem, Hoechts-Sara Pero (Mi) Italy. Such a system comprises a solid unsaturated polyester resin under trade name ALFTALAT VAN 1743, having a Tg > 52 °C and an urethane adduct with acrylic functional groups under trade name ADDITOL 03546, having a Tg > 47 °C. The properties of this system have be described in European Coating Journal n° 9/95 606-608 (1995). Also non-acrylate binder systems are useful in the present invention, e.g. a powder composed of a mixture of an unsaturated polyester resin in which maleic acid or fumaric acid is incorporated and a polyurethane containing a vinylether. Such a binder system has been developed by DSM resins of the Netherlands and the properties thereof have been described in European Coating Journal n° 3/96 115-117 (1996).

For the UV curing to proceed it is necessary that a photoinitiator is present. Very useful initiators are sulphonium salts as e.g. triarylsulphonium salts, triarylsulphoniumhexafluorophosphate, benzophenones, etc. Typical very useful photoinitiators in the context of this invention, are, e.g., 2-hydroxy-2-methyl-1-phenyl-propan-1-one, compound I, a mixture of compound I and compound II and compound III :

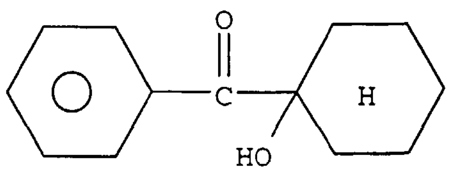

Compound I

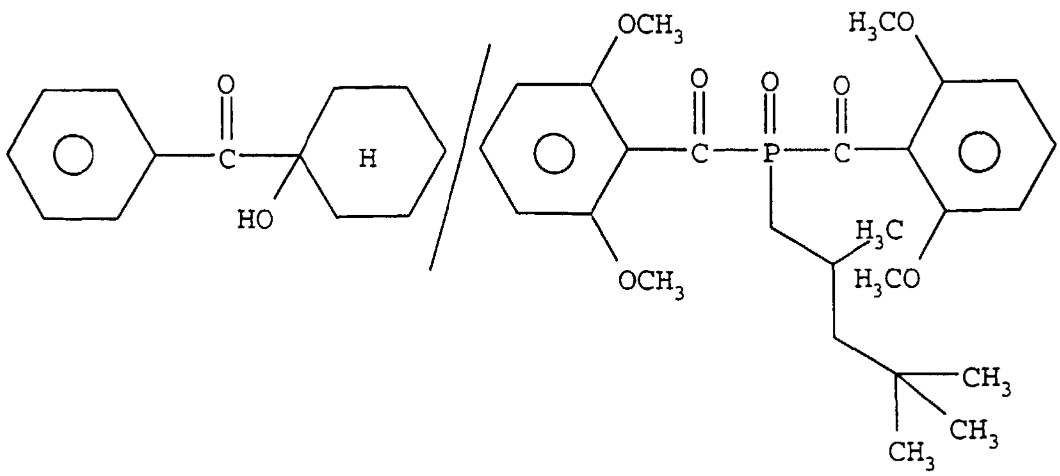

Compound I          Compound II

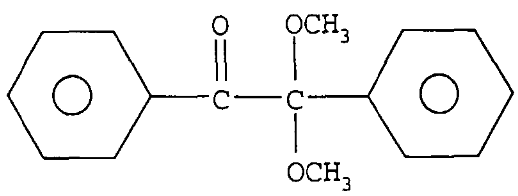

Compound III

The initiator (photoinitiator) is preferably incorporated in the toner particles together with the UV curable system.

It is, however, also possible, in toner particles as disclosed in EP-A-821 281, to have the pair radiation curable compound and initiator in various combinations :

i) both a UV-curable compound (or a mixture of UV-curable compounds) and a photoinitiator (or mixture of photoinitiators) are only incorporated in the toner particles, not in the substrate,
ii) both a UV-curable compound (or a mixture of UV-curable compounds) and a photoinitiator (or mixture of photoinitiators) are in incorporated in the toner particles, and a UV-curable compound (or a mixture of UV-curable compounds) is incorporated in the substrate,
iii) a UV curable compound (or a mixture of UV-curable compounds) is incorporated in the toner particles and both a UV-curable compound (or a mixture of UV-curable compounds) and a photoinitiator (or mixture of photoinitiators) are incorporated in the substrate,
iv) a UV curable compound (or a mixture of UV-curable compounds) is incorporated in the toner particles and a photoinitiator (or mixture of photoinitiators) is incorporated in the substrate.

When the photoinitiator and/or the UV curable compound are incorporated in the substrate, it is preferred that the substrate comprises a toner receiving layer.

For further enhancing the quality of the polymeric mask that is printed on the conductive layer of the PCB-precursor, it is preferred to use toner particles having an average volume diameter $d_{v50}$ smaller than 10 µm, more prefer-

able $d_{v50}$ is such that $2 \leq d_{v50} \leq 9$ µm. The particle size distribution of the toner particles is preferably a Gaussian distribution wherein the ratio of the standard deviation to the $d_{v50}$ (i.e. the coefficient of variability, v) is lower than 0.5, more preferably lower than 0.3. It proved to be beneficial when toner particles with an absolute average charge to mass ratio (|q|) to $2\ \mu C/g < |q| < 15\ \mu C/g$ , preferably to $5\ \mu C/g < |q| < 8\ \mu C/g$ . The absolute average charge to mass ratio was measured by mixing a mixture toner particles (4 to 8 % by weight) and carrier particles in a standard tumbling set-up for 10 min. The developer mixture was run in the development unit (magnetic brush assembly) for 5 minutes, after which the toner particles were, via a magnetic brush assembly, applied as a monolayer of charged toner particles on a charged toner conveyer (a CTC). From said CTC the toner particles were under vacuum pulled to an accurately weighed filter paper (weight was WP in g), which was shielded in a Faraday cage. The amount of charge that arrived, after 5 minutes vacuum pulling, at said filter paper was measured with a Coulomb meter in µC. The filter paper with the toner particles was weighed again, giving weight WPT in g. The charge to mass ratio was then determined as µC/(WPT - WP). Such toner particles have been described in EP-A-811 894.

Moreover it is preferred that the charge distribution, measured, as described in EP-A 675 417 is narrow, i.e. shows a distribution wherein the coefficient of variability (v), i.e. the ratio of the standard deviation to the average value, is equal to or lower than 0.33, preferably equal to or lower than 0.25. Means for producing toner particles with a low average charge and a narrow charge distribution have been disclosed, for positively chargeable toners in EP-B 654 152 and for negatively chargeable toners in EP-B 650 609 and EP-A 650 610. These three references are incorporated herein by reference. In essence the method for producing toners with low average charge and narrow charge distribution consists in mixing in the toner resin a compound having a volume resistivity lower than the volume resistivity of the toner resin. Preferred compounds having lower volume resistivity than the toner resin are onium compounds.

It was found that the printing quality of the polymeric mask was still better when said toner particles were spherical so that the ratio of the length of the long axis of the projected microscopic image of said particles to the length of the short axis, is between 1.00 and 1.40. The sphericity is determined by photographing the particles under an optical microscope and determining the long and short axis (both axis crossing the centre of gravity of the shadow image of the particle) and the ratio of the length of both axis (i.e. the sphericity) for at least 20 particles. From these twenty measurements, an average sphericity is calculated. Such particles have been described in EP-A-715 218.

In the method according to this invention, an amount equal to or larger than 7 g/m2 of toner particles, preferably equal to or larger than 10 $g/m^2$ is applied to said conductive layer when $D_{max}$ is printed.

The PCB-precursor to be printed, can have any shape, e.g., it can be in sheet form, in web form, it can be moulded articles, etc. When the substrate is a moulded article, it can have any shape and any surface topology. It can e.g. be cylindrical with a smooth conductive surface, it can be flat with a undulated conductive surface, etc.

This is one of the advantages of direct electrostatic printing, without the use of an intermediate image receiving member. It is possible to print on the conductive layer of a PCB precursor as image receptive member by using an intermediate image receiving member. In US 5,305,026, US 5,353,105 and EP 743572 a device is described comprising an intermediate recording medium upon which the toner image is jetted using a DEP-process, after which said toner image is transferred to a final receiving member by means of an electrostatic field. The toner is then fixed on said final receiving member. In the other embodiment said two processes are performed in a single step : i.e. the toner image is jetted upon a heated intermediate image receptive member from which the toner image is transferred and fused at the same time (transfused) to the final image receptive member.

Since in such process image transfer has to take place and high image quality with high image sharpness can only be obtained by using intimate contact between said final image receptive member and said intermediate image receptive member, said method of printing is only suitable for very flat final receptive members. The method according to this invention can, as explained above, be used substrates having any shape.

Description of a DEP device for use in the method according to this invention

This invention comprises also a DEP device for printing on a substrate having a conductive layer , comprising :

a means for delivering toner particles, said means having a surface (103a) for carrying charged toner particles coupled to a voltage source for providing an electric potential, V1, on said surface,

means (108, 113) for passing said substrate (109) by said surface (103a) in a direction A with said conductive layer (112) facing said surface,

a means (115) for applying an electric potential V4 to said conductive layer, V4 being different from V1 for providing an electric potential difference , |V|, between said surface (103a) and said conductive layer (112) for creating a flow (104) of charged toner particles from said surface to said conductive layer,

a printhead structure (106) comprising printing apertures (107) and control electrodes, placed in said flow of toner particles, at a distance L of said conductive layer and wherein said control electrodes are coupled to a voltage source for providing an image-wise variable voltage V3 to said control electrodes for image-wise modulating said

flow of toner particles,

a means for adjusting said potential difference |V| to said distance L so that $0.5 \leq |V|/L \leq 2.5$ , and

means (110) for fixing said toner particles to said conductive layer of said substrate.

A non limitative example of a DEP device for implementing the method according to the present invention for printing on a substrate having a conductive surface is shown in figure 1 and comprises : means (115) for applying an electric potential (V4) on a conductive layer (112) on an insulating substrate (109),

means for applying an electric potential (V1) to a surface carrying charged toner particles (103a), V1 being different from V4, (the difference between V4 and V1 is the value |V|)for creating an electric field between the conductive layer and the surface carrying toner particles, wherein a flow (104) of charged toner particles from a surface carrying charged toner particles (103a)) to said conductive layer (112) is created,

a printhead structure (106) comprising printing apertures (107) and control electrodes (106a),and a shield electrode (106b) in said flow of charged toner particles,

a voltage source (V3) for applying a variable voltage on said control electrodes, for image-wise modulating said flow of charged toner particles,

a voltage source V2 for applying an electric potential on said shield electrode,

means (108, 113) for passing said substrate (109) in the direction of arrow A through the flow of toner particles in the vicinity of the printing apertures (107) so that toner particles are deposited on said conductive layer from the image-wise modulated flow of charged toner particles and

means (110) for fixing said toner particles to said substrate.

In the figure, said surface (103a) carrying charged toner particles, is the surface of the stationary sleeve of a magnetic brush (103) wherein a magnetic core (103b) is rotated. The charged toner particles are present on said sleeve together with magnetic carrier particles from a multi-component developer (102) in developer reservoir (101). The magnetic brush (103) used in a DEP device for implementing the method according to the present invention can be either of the type with stationary sleeve (103a) and rotating core (103b) or of the type with rotating core and rotating sleeve. When using a magnetic brush as means for creating a flow of toner particles from the "hairs" of multi-component developer on the sleeve of the magnetic brush, several types of magnetic carrier particles, such as described in EP-A 675,417 can be used in co-operation with non-magnetic toner particles.

The device is exemplified in figure 1, with a magnetic brush directly delivering a flow of toner particles from the "hairs" of multi-component developer on the magnetic brush. It is clear that the method of this invention can also be implemented with a DEP printing device where the flow of charged toner particles originates from a magnetic brush carrying "hairs" of magnetic toner particles only, or with a DEP device wherein the flow of charged toner particles originates from the surface of a "charged toner conveyor" whereon the particles are deposited by, e.g. a magnetic brush. Also DEP devices wherein the flow of charged toner particles originates from a surface carrying non-magnetic mono-component developer.

In figure 1, shield electrode 106b faces the toner delivering means and control electrodes (106a) around printing apertures (107), face the toner receiving member. It is clear that the location and/or form of the shield electrode (106b) and the control electrode (106a) can, in other embodiments of a device for a DEP method, be different from the location shown in fig. 1.

Said means for applying an electric potential on said conductive layer , comprises means for contacting said conductive layer and connecting it to an appropriate voltage source or to the earth. Said means for contacting said conductive layer comprises preferably a conductive brush. The hairs of said brush can be metallic fibres, carbon fibres, etc. When using a conductive brush it is preferred that said brush contacts said conductive layer only at one or more of the edges of the surface to be printed. Since said brush when only contacting edges of the surface to be printed, it does not touch the image parts, that can be made up with not yet fused or fixed toner particles, so the device according to the present invention can be used for printing multiple images (multiple monochrome image or multiple polychrome/reactive images) to form an image with interacting/reacting components on top of each other and fixing all layers of deposited toner particles at once.

The means for contacting said conductive layer can also be contacting rollers made of conductive material, preferably metal as aluminium, stainless steel. When using a roller it is preferred that the surface of such a roller is formed by a conductive elastomeric compound, e.g., by a rubber filled with carbon black.

The value of V3 is selected, according to the modulation of the image forming signals, between the values V30 and V3n, on a time-basis or grey-level basis. Voltage V4 is applied to the conductive charge applying device. In other embodiments of the present invention multiple voltages V20 to V2n can be used.

A DEP device making use of the above mentioned marking particles can be addressed in a way that enables it to give black and white. It can thus be operated in a "binary way", useful for black and white text and graphics and

useful for classical bi-level half-toning to render continuous tone images or images of different "masking levels".

A DEP device according to the present invention is especially suited for rendering an image with a plurality of grey levels: i.e. a plurality of "masking levels". This is especially suited for varying the mask thickness according to the image input values : e.g. conductor paths with a narrow line-width are printed with a toner mask thickness that is thick enough to prevent the underlying copper layer to be etched in the following etching process but thin enough to obtain a sharp and narrow line pattern, while conductor path or zones with larger dimension are provided with a thicker toner layer so that etching of the underlying copper layer is almost impossible. Grey level printing can be controlled by either an amplitude modulation of the voltage V3 applied on the control electrode 6a or by a time modulation of V3. By changing the duty cycle of the time modulation at a specific frequency, it is possible to print accurately fine differences in grey levels. It is also possible to control the grey level printing by a combination of an amplitude modulation and a time modulation of the voltage V3, applied on the control electrode.

The DEP-device useful for practising said invention can have a single-pass printing concept in which a PCB-precursor with its conductive layer connected to a voltage source is moved in one direction near a printhead structure that is able to print all image information in a single pass, i.e. at a resolution of e.g. 300 dpi, (i.e. 300 dots per inch, where 1 dpi = 1 dot per 2.54 cm) said printhead structure has many different printing apertures at a pitch of at most 85 µm.

By adapting the aspect ratio of rectangular printing apertures and mounting the printhead structure so that the largest dimension of said apertures is located in a direction parallel with the printing direction (direction of Arrow A in figure 1) it becomes possible to print very sharp lines of high density. A printhead structure with rectangular apertures and being positioned so that the largest dimension of the apertures is orthogonal to the printing direction (direction of arrow A in fig.1) can be used for obtaining very fast covering of mask areas of larger dimensions. Thus the combination of two printhead structures with rectangular printing apertures can be combined and separately be driven either for fast printing of large area's or for accurately printing of very fine lines. The same possibility exists when using a printhead structure having at least two rows of rectangular printing apertures with a longer and a shorter side and one of said rows of printing apertures is positioned in said printhead structure so as to have said longer side of said printing apertures parallel with said direction A and a other of said rows of printing apertures is positioned in said printhead structure so as to have said smaller side of said printing apertures parallel with said direction A.

In an other implementation said printhead structure can be mounted on a shuttle-device so that said substrate is moved in one direction and said printhead structure is fixed on a "shuttle arm" that can move in an other direction (preferably substantially orthogonal to said first direction) over said substrate. When in such a printing device, the PCB-precursor is in sheet form, it may be beneficial to fix the sheet in a frame that is moved in one direction and said printhead structure is fixed on a "shuttle arm" that can move in an other direction (preferably substantially orthogonal to said first direction) over said substrate. Means and ways to incorporate a DEP-device in shuttling printers have been disclosed in European Application Number 97203821, filed December 5, 1997. This shuttle concept has the advantage that the design of said printhead structure can be made less complex (e.g. only a single row of printing apertures with small diameter but at a higher pitch than necessary in order to obtain a certain resolution in single pass), and all image mask information is printed in different swaths of said printhead structure. Compared to e.g. electrophotographic printers said shuttle concept can deposit a large amount of toner on different accurately determined pixel positions upon said substrate, leading to thick protective toner masks.

Moreover by adapting the aspect ratio of rectangular printing apertures and mounting the printhead structure so that the largest dimension of said apertures is located in a direction parallel with the printing direction (direction of Arrow A in figure 1) it becomes possible to print very sharp lines of high density in a single print direction. By printing all the image mask information in many different swaths using said printhead structure yielding very sharp lines in said print direction, an image mask layout with many very sharp-edged paths can be obtained. This concept for enhancing the sharpness of individual conductor paths can also be provided in two (essentially orthogonal) directions by implementing two different printhead structures (essentially orthogonal to each other) both located upon a shuttle movement system (in an essentially orthogonal position).

One or more printhead structures with rectangular apertures with the largest dimension in the print direction (printhead structure PSP) can be combined with one or more printhead structures having rectangular apertures with the largest dimension orthogonal to said print direction (printhead structure PSO) on a shuttle, in this case the large area's can be printed very fast by printing them with PSO and the fine lines can be printed without spread by printing them by the PSP. Due to the fact that DEP printing is essentially digital it is possible to drive a separate printhead for a given structure. Thus the present invention encompasses a DEP printer with a shuttle concept, comprising means for moving a PCB precursor in a first direction A, and means for connecting a conductive layer on said PCB-precursor to a voltage source, means for moving a shuttle having a swath width (SWS) in a second direction, different from said first direction, said shuttle carrying a DEP engine having a means for delivering toner particles having a surface whereon charged toner particles are present for providing a flow of said toner particles from said surface to said PCB-precursor, a printhead structure (106) with a least two rows of printing apertures with rectangular printing apertures and control electrodes (106"),interposed in said flow of toner particles for image-wise controlling said flow, wherein one of said rows

of printing apertures is positioned in said printhead structure so as to have said longer side of said printing apertures parallel with said direction A and an other of said rows of printing apertures is positioned in said printhead structure so as to have said smaller side of said printing apertures parallel with said direction A. Any combination of said printhead structures in a still more complex device falls also within the scope of the present invention.

EXAMPLES

The printhead structure

A printhead structure (106) was made from a polyimide film of 50 µm thickness, double sided coated with a 5 µm thick copper film. The printhead structure (106) had two rows of printing apertures. On the back side of the printhead structure, facing the image receiving member, a square shaped control electrode (106a) was connected over 2 MΩ resistors to a HV 507 (trade name) high voltage switching IC, commercially available through Supertex, USA, that was powered from a high voltage power amplifier. On the front side of the printhead structure, facing the toner delivery means, a common shield electrode (106b) was present. The printing apertures had an aperture diameter of 100 µm. The total width of the square shaped copper control electrodes was 250 µm, their internal aperture width was also 100 µm. The width of the aperture in the common shield electrode was 300 µm. Said printhead structure was fabricated in the following way. First of all the control electrode pattern was etched by conventional copper etching techniques. Then the shield electrode pattern was etched by conventional copper etching techniques. The apertures were made by a step and repeat focused excimer laser making use of the control electrode patterns as focusing aid. After excimer burning the printhead structure was cleaned by a short isotropic plasma etching cleaning. Finally a thin coating of PLASTIK70 (trade name), commercially available from Kontakt Chemie, was applied over the control electrode side of said printhead structure.

The first means for delivering toner particles

The first means for delivering toner particles (101) was magnetic brush of the stationary core/rotating sleeve type.

The magnetic brush assembly (103) was constituted of the so called magnetic roller, which in this case contained inside the roller assembly a magnetic core, showing 9 magnetic poles of 50 mT (milliTesla) or 500 Gauss magnetic field intensity with a fall-off zone. The magnetic roller contained also a sleeve, fitting around said magnetic core, and giving to the magnetic brush assembly an overall diameter of 20 mm. The sleeve was made of finely roughened stainless steel.

A doctoring blade was used to meter a small amount of developer onto the surface of said magnetic brush assembly. The sleeve was rotating at 100 rotation per minute (rpm).

The surface of the sleeve carrying the developer as described immediately below, is in this case the surface carrying charged toner particles.

Developer (DEV1)

i) Carrier particles

A macroscopic "soft" ferrite carrier consisting of a MgZn-ferrite with average particle size 50 µm, a magnetisation at saturation of 540 $\mu Tm^3/kg$ or 29 emu/g was provided with a 1 µm thick acrylic coating. The material showed virtually no remanence.

ii) Toner particles (T1)

The toner used for the experiment had the following composition : 97 parts of a co-polyester resin of fumaric acid and propoxylated bisphenol A, having an acid value of 18 and volume resistivity of $5.1 \times 10^{16}$ Ω.cm was melt-blended for 30 minutes at 110°C in a laboratory kneader with 3 parts of Cu-phthalocyanine pigment (Colour Index PB 515:3). A resistivity decreasing substance - having the following structural formula :

$$(CH_3)_3N^+C_{16}H_{33}Br^-$$

- was added in a quantity of 0.5 % with respect to the binder. It was found that - by mixing with 5 % of said ammonium salt - the volume resistivity of the applied binder resin was lowered to $5 \times 10^{14}$ Ω.cm.

After cooling, the solidified mass was pulverised and milled using an ALPINE Fliessbettgegenstrahlmühle type 100AFG (trade name) and further classified using an ALPINE multiplex zig-zag classifier type 100MZR (trade name). The resulting particle size distribution of the separated toner, measured by Coulter Counter model Multisizer (trade name), was found to be 6.3 µm average by number and 8.2 µm average by volume. In order to improve the flowability of the toner mass, the toner particles were mixed with 0.5 % of hydrophobic colloidal silica particles (BET-value 130 $m^2/g$).

An electrostatographic developer was prepared by mixing said mixture of toner particles and colloidal silica in a 4 % ratio (w/w) with carrier particles. The tribo-electric charging of the toner-carrier mixture was performed by mixing said mixture in a standard tumbling set-up for 10 min. The developer mixture was run in the development unit (magnetic brush assembly) for 5 minutes, after which the toner was sampled and the tribo-electric properties were measured, according to a method as described in EP-A-675 417, giving q = -7.1 fC, q as defined in said EP-A.

Developer DEV2

Developer DEV2 was the same as developer DEV1, except for the toner particles T2.

Preparation of toner T2

68 parts of solid unsaturated polyester resin having a Tg ≥ 45 °C available from Hoechst High Chem, Hoechts-Sara, Pero (Mi) Italy under trade name ALFTALAT VAN 1743, 29 parts of an aliphatic urethane adduct with acrylic functional groups, having a Tg ≤ 52 °C, available from Hoechst High Chem, Hoechts-Sara, Pero (Mi) Italy under trade name ADDITOL 03546 and 3 parts of

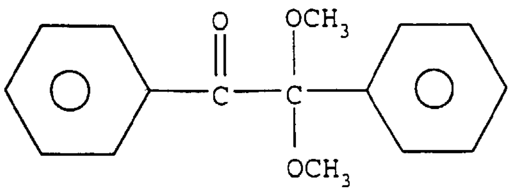

**[0068]** , available from Ciba-Geigy, Basel, Switserland under trade name IRGACURE 651 were melt-blended for 30 minutes at 110 °C in a laboratory kneader.

After cooling the solidified mass was pulverised and milled using an ALPINE Fliessbettgegenstrahlmühle type 100AFG (tradename) and further classified using an ALPINE multiplex zig-zag classifier type 100MZR (tradename). The average particle size of the separated toner was measured by Coulter Counter model Multisizer (trade name) was found to be 8.0 mm by volume. The clear toner CT had a meltviscosity at 120 °C of 195 Pas.

To improve the flowability of the toner mass the toner particles were mixed with 0.3 % of hydrophobic colloidal silica particles (BET-value 130 $m^2/g$).

The second means for delivering toner particles T

The second means for delivering toner particles was a commercially available toner cartridge comprising non magnetic mono component developer, (The COLOR LASER TONER CARTRIDGE MAGENTA M3760GIA), for the COLOR LASER WRITER (Trade names of Apple Computer, USA). The toner bearing surface is the surface of an aluminium roller, whereon tone particles are applied by a feeding roller (111) The toner particles carried a negative charge.

PRINTING EXAMPLE 1 (PE1)

The distance between the front side of the printhead structure (106) and the sleeve of the magnetic brush assembly (103) of said first toner delivery means, was set at 450 µm. The distance L, between the surface of the conductive layer of the substrate (109) to be printed and the back side of the printhead structure (106) (i.e. control electrodes 106a) was set to 500 µm and the substrate travelled at 1 cm/sec on a shuttle mechanism in two swaths. To the individual control electrodes an (image-wise) voltage V3 between 0 V and -300 V was applied. The shield electrode was grounded: V2 = 0 V. The magnetic brush assembly (103) was connected to an AC power supply with a square wave oscillating field of 600 V at a frequency of 3.0 kHz with 0 V DC-offset.

On the magnetic brush developer DEV1 was used.

The printing proceeded on a sheet of FR4 (commercially available from Isola, Germany) with 35 µm thick layer of copper. An electric field between the conductive layer i.e. the copper layer) and the surface bearing toner particles (i.e. the sleeve of the magnetic brush) was provided by a brush with carbon-black filled conductive hairs and was placed

at 50 mm from the printing nip. Said brush (105) was connected to a high voltage power supply of + 1500 V. In this example $|V|/L = 3.0$ . An image with individual lines and an area of $D_{max}$ was printed. Said substrate was further etched by conventional wet etching procedures.

PRINTING EXAMPLE 2 (PE2)

Printing example 1 was repeated except for the use of developer DEV2, containing UV-curable toner particles T2, and the substrate, a polyimide foil with 5 µm thick copper layer (Sheldahl). On the layer of copper a voltage of + 1000 V was applied. In this example $|V|/L = 2.0$ .

An image with individual lines and an area of $D_{max}$ was printed. Immediately after fixing said toner images a short UV-curing was performed (0.5 s high pressure mercury lamp with intensity of 80 W/cm).

The substrate was further etched by conventional wet etching procedures.

PRINTING EXAMPLE 3 (PE3)

Printing example 2 was repeated except fro the voltage applied to the layer of copper. On the layer of copper a voltage of + 500 V was applied. In this example $|V|/L = 1.0$ . An image with individual lines and an area of $D_{max}$ was printed. Immediately after fixing said toner images a short UV-curing was performed (0.5 s high pressure mercury lamp with intensity of 80 W/cm).

The substrate was further etched by conventional wet etching procedures.

PRINTING EXAMPLE 4 (PE4)

The printhead structure as described above, was mounted in a PVC-frame (116), and was bent with frictional contact over the surface of the roller of said second means for delivering toner particles whereon charged toner particles of toner T3 were present. A 50 µm thick polyurethane coating was used as self-regulating spacer means to keep the distance between said roller and the printhead structure constant. The distance L, between the surface of the conductive layer of the substrate (109) to be printed and the back side of the printhead structure (106) (i.e. control electrodes 106a) was set to 1000 µm and the substrate travelled at 3 cm/sec. To the individual control electrodes an (image-wise) voltage V3 between +280 V and 0 V was applied. To the shield electrode a voltage of +50 V was set. The toner roll of said second toner delivery means was connected to an AC-power source with a square wave oscillating field of 280 Vptp (Volts peak to peak) of 2.75 kHz with +200 V DC-offset.

As substrate to be printed, a polyimide foil with 5 µm thick copper layer was used (Sheldahl), and said voltage applied to said conductive layer was 2500 V. The ratio $|V|/L$ was 2.5. An image with individual lines and an area of $D_{max}$ was printed. The substrate was further etched by conventional wet etching procedures.

PRINTING EXAMPLE 5 (PE5)

Printing Example PE4 was repeated except for the voltage applied to the layer of copper, which was now + 2000 V. So that the ratio $|V|/L = 2.0$ .

PRINTING EXAMPLE 6 (PE6)

Printing Example PE4 was repeated except for the voltage applied to the layer of copper, which was now + 1500 V. So that the ratio $|V|/L = 1.5$ .

PRINTING EXAMPLE 7 (PE7)

Printing Example PE4 was repeated except for the voltage applied to the layer of copper, which was now + 1000 V. So that the ratio $|V|/L = 1.0$ .

PRINTING EXAMPLE 8 (PE8)

Printing Example PE4 was repeated except for the voltage applied to the layer of copper, which was now + 500 V. So that the ratio $|V|/L = 0.5$ .

PRINTING EXAMPLE 9 (PE9)

Printing Example PE4 was repeated except for the voltage applied to the layer of copper, which was now + 250 V. So that the ratio |V|/L = 0.25 .

PRINTING EXAMPLE 10 (PE10)

Printing Example PE4 was repeated except for the voltage applied to the layer of copper, which was now + 0 V, i.e. the layer of copper was connected to ground potential. So that the ratio |V|/L = 0 .

EVALUATION OF THE RESULTS

The fixed images obtained from examples 1-10 were further etched by conventional methods as well known to those skilled in the art.

An aqueous solution of $FeCl_3$ (40 % wt/wt) was used at 50 °C in a spray-etch apparatus commercially available from Romex BV, Netherlands (Type 1200). Typical etching times for fresh etchings solutions were 110 seconds for example 1 to 40 seconds for the other examples. After this etching process the samples were rinsed in deionised water and the toner mask layer was removed in organic solvent (acetone, methylethylketone, Shipley Microposit Remover 1112A, ...).

The line width of the resultant copper conductors was measured and evaluated for edge sharpness. The evaluation was done by giving the quality a ranking from 0 to 5, wherein 0 is bad and 5 is very good, these figure are summarised in table 1 under column marked "line".

The areas of $D_{max}$ were evaluated for the presence of tiny holes and craters as clearly visible by scanning electron microscopy. The evaluation was done by giving the quality a ranking from 0 to 5, wherein 0 is bad and 5 is very good, these figure are summarised in table 1 under column marked "area".

The overall quality was judged by multiplying the values in column "line" by the values in column "area". The result of the multiplication is given in column marked "Li x Ar".

TABLE 1

| example | Voltage | \|V\|/µm | line | area | Li x Ar |
|---|---|---|---|---|---|
| PE1 | 1500 | 3.00 | 1.50 | 2.00 | 3.00 |
| PE2 | 1000 | 2.00 | 2.00 | 3.50 | 7.00 |
| PE3 | 500 | 1.00 | 2.50 | 3.00 | 7.50 |
| PE4 | 2500 | 2.50 | 1.00 | 3.50 | 3.50 |
| PE5 | 2000 | 2.00 | 2.00 | 3.50 | 7.00 |
| PE6 | 1500 | 1.50 | 2.00 | 3.00 | 7.00 |
| PE7 | 1000 | 1.00 | 2.00 | 3.00 | 6.00 |
| PE8 | 500 | 0.50 | 2.50 | 2.00 | 5.00 |
| PE9 | 250 | 0.25 | 2.00 | 1.00 | 2.00 |
| PE10 | 0 | 0.00 | 0.00 | 0.00 | 0.00 |

From table 1 it is clear that when |V|/L is between 0.5 and 2.50 acceptable overall results are obtained, and that when |V|/L is between 1 and 2 (limits included) excellent overall quality is obtained.

Thus DEP printing according to the present invention can offer an excellent solution to the problem of fast and low cost fabrication methods for PCB plates.

It must be clear to those skilled in the art that alterations can be made to this concept of printing without departing from the spirit of the present invention, the invention is exemplified using negative toner particles and thus positive voltages on the layer of copper, but is it clear that the invention works equally well when using positive charge toner particles and negative potentials on the layer of copper. It must be clear that any method of charging the surface of a non-conducting receptive member can be used according to the same object of the present invention. Surface charging can e.g. be performed by charged contact rollers, corona or scorotron devices, frictional contact charging means, etc. Printing apertures with elliptic form are also equally well suitable for DEP printhead structures as the ones described with

rectangular apertures in this disclosure.

## Claims

1. A method for the production of a printed circuit board comprising the steps of :

   - bringing a PCB-precursor having a conductive layer on an insulating substrate near a surface carrying charged toner particles said conductive layer facing said surface,
   - providing an electrical potential difference of |V| volts, between said conductive layer and said surface carrying charged toner particles, for creating a flow of charged toner particles from said surface to said conductive layer,
   - positioning a printhead structure with printing apertures and control electrodes between said surface and said conductive layer, at a distance L µm from said conductive layer, for image-wise modulating said flow of charged toner particles,
   - adapting said potential difference |V| and said distance L to each other so that $0.5 \le |V|/L \le 2.5$ , wherein |V|/L is expressed in Volts/µm,
   - depositing said toner particles image wise on said conductive layer,
   - fixing said toner particles to said conductive layer for forming a polymeric etching mask on said conductive layer for forming protected and unprotected parts on said conductive layer and
   - etching said unprotected parts of said conductive layer.

2. A method according to claim 1, wherein said potential V and said distance L are adapted to each other so that $1 \le |V|/L \le 2$ .

3. A method according to claim 1 or 2 wherein said toner particles comprise UV-curable compounds.

4. A method according to any of claims 1 to 3, wherein said toner particles have a volume average diameter $d_{v50}$ so that $2\ \mu m \le d_{v50} \le 9\ \mu m$

5. A method according to any of the preceding claims, wherein said toner particles have absolute average charge to mass ratio (|q|) so that $2\ \mu C/g < |q| < 15\ \mu C/g$

6. A method according to any of the preceding claims, wherein said toner particles are spherical and show a projected microscopic image with long axis, with length LA and a short axis, with length LS, and wherein LA/LS is between 1.0 and 1.4.

7. A method according to any of the preceding claims , wherein an amount equal to or larger than 7 g/m$^2$ of toner particles is applied to said conductive layer when $D_{max}$ is printed.

8. A DEP device for printing on a substrate having a conductive layer , comprising :

   a means for delivering toner particles with a surface (103a) for carrying charged toner particles coupled to a voltage source for providing an electric potential, V1, on said surface,
   means (108, 113) for passing said substrate (109) by said surface (103a) in a direction A with said conductive layer (112) facing said surface,
   a means (115) for applying an electric potential V4 to said conductive layer, V4 being different from V1 for providing an electric potential difference , |V|, between said surface (103a) and said conductive layer (112) for creating a flow (104) of charged toner particles from said surface to said conductive layer,
   a printhead structure (106) comprising printing apertures (107)and control electrodes, placed in said flow of toner particles, at a distance L of said conductive layer and wherein said control electrodes are coupled to a voltage source for providing an image-wise variable voltage V3 to said control electrodes for image-wise modulating said flow of toner particles,
   a means for adjusting said potential difference |V| to said distance L so that $0.5 \le |V|/L \le 2.5$ , and
   means (110) for fixing said toner particles to said conductive layer of said substrate.

9. A DEP device according to claim 8, wherein said means for applying said electrical potential V4 comprises a conductive brush.

10. A DEP device according to claim 8, wherein said means for applying said electrical potential V4 comprises a conductive roller.

**11.** A DEP device according to any of claims 8 to 10, wherein said printing apertures are rectangular having a longer and shorter side, and wherein said printhead structure (106) is positioned so that said longer side of said printing apertures (107) is parallel with said direction A.

**12.** A DEP printing device according to any of claims 8 to 10, wherein said printhead structure comprises at least two rows of rectangular printing apertures with a longer and a shorter side and one of said rows of printing apertures is positioned in said printhead structure so as to have said longer side of said printing apertures parallel with said direction A and an other of said rows of printing apertures is positioned in said printhead structure so as to have said smaller side of said printing apertures parallel with said direction A.

**13.** A DEP device according to any of claims 8 to 12, wherein said substrate moves in one direction and said printhead structure is fixed on a "shuttle arm" that moves in a substantially orthogonal to said first direction.

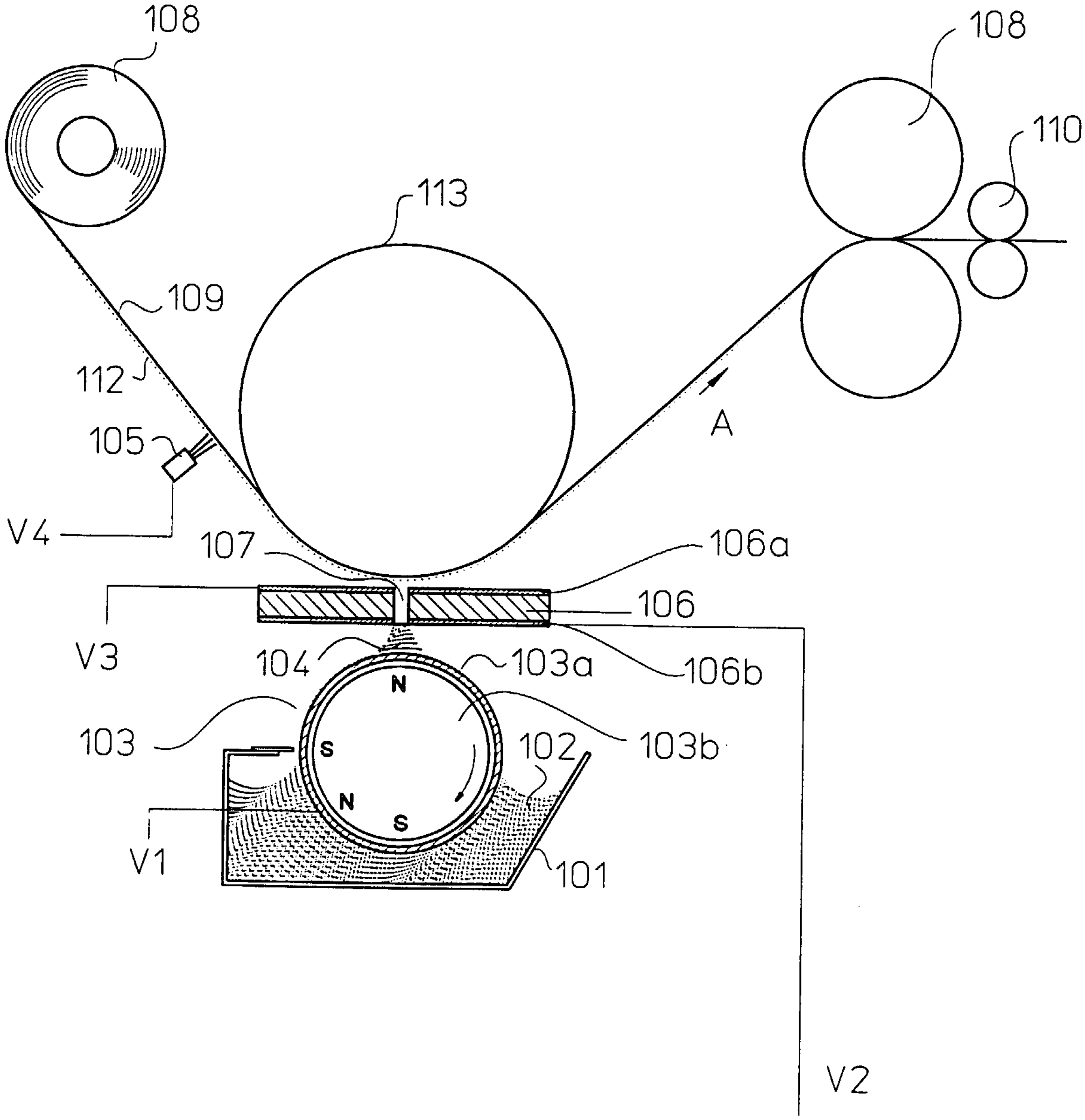
108
108
110
113
109
112
105
A
V4
107
106a
106
V3
104
103a
106b
N
103
S
103b
102
N
S
V1
101
V2

Fig.1

European Patent Office

# EUROPEAN SEARCH REPORT

Application Number
EP 98 20 1302

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 706 094 A (AGFA GEVAERT NV) 10 April 1996<br>* page 2, line 10 - line 43; claims * | 1,7,8 | G03G15/34<br>H05K3/06 |
| D,A | EP 0 715 218 A (AGFA GEVAERT NV) 5 June 1996<br>* abstract; claims * | 1,3-6,8 | |
| D,E | EP 0 849 645 A (AGFA GEVAERT NV) 24 June 1998<br>* claims; figures * | 1,8-11, 13 | |
| A | EP 0 812 696 A (AGFA GEVAERT NV) 17 December 1997<br>* claims; figures * | 1,8,11, 12 | |
| | | | TECHNICAL FIELDS SEARCHED (Int.Cl.6) |
| | | | G03G<br>H05K |

The present search report has been drawn up for all claims

| Place of search | Date of completion of the search | Examiner |
|---|---|---|
| THE HAGUE | 17 September 1998 | Lipp, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 98 20 1302

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-1998

| Patent document cited in search report | Publication date | Patent family member(s) | Publication date |
|---|---|---|---|
| EP 0706094 A | 10-04-1996 | JP 8272134 A | 18-10-1996 |
| | | US 5558969 A | 24-09-1996 |
| EP 0715218 A | 05-06-1996 | DE 69409533 D | 14-05-1998 |
| | | DE 69409533 T | 12-11-1998 |
| | | JP 8272135 A | 18-10-1996 |
| | | US 5633110 A | 27-05-1997 |
| EP 0849645 A | 24-06-1998 | JP 10181070 A | 07-07-1998 |
| EP 0812696 A | 17-12-1997 | DE 69700008 D | 10-06-1998 |
| | | DE 69700008 T | 19-11-1998 |
| | | JP 10052937 A | 24-02-1998 |

EPO FORM P0459

For more details about this annex : see Official Journal of the European Patent Office, No. 12/82